# EUROPÄISCHE PATENTSCHRIFT

(11) **EP 2 376 753 B1**
(45) Veröffentlichungstag und Bekanntmachung des Hinweises auf die Patenterteilung: **13.06.2018**
(21) Anmeldenummer: 09763924.9
(22) Anmeldetag: 25.11.2009
(51) Int. Cl.: F01N 5/02, F02M 39/02, F02G 5/02, H01L 35/28, H01L 35/30

(54) **VORRICHTUNG ZUR ERZEUGUNG ELEKTRISCHER ENERGIE AUS EINEM ABGAS**
DEVICE FOR PRODUCING ELECTRICAL ENERGY FROM EXHAUST GAS
DISPOSITIF PERMETTANT LA PRODUCTION D'ÉNERGIE ÉLECTRIQUE À PARTIR DE GAZ D'ÉCHAPPEMENT

(30) Priorität: 17.12.2008 DE 102008063487
(43) Veröffentlichungstag der Anmeldung: 19.10.2011
(73) Patentinhaber: Continental Automotive GmbH, 30165 Hannover (DE)
(72) Erfinder: BRÜCK, Rolf, 51429 Bergisch Gladbach (DE); LIMBECK, Sigrid, 53804 Much (DE)
(86) Internationale Anmeldenummer: PCT/EP2009/065810
(87) Internationale Veröffentlichungsnummer: WO 2010/076098

(56) Entgegenhaltungen:
- WO-A1-2005/098225
- WO-A1-2007/026432
- WO-A1-2009/138412
- DE-A1-102006 057 662
- FR-A1- 2 512 499
- JP-A- 2006 083 725
- JP-A- 2006 214 350
- US-A1- 2005 217 714

## Beschreibung

Die vorliegende Erfindung betrifft eine Vorrichtung zur Erzeugung elektrischer Energie aus dem Abgas einer Verbrennungskraftmaschine mittels eines Generators. Damit ist insbesondere ein Generator zur Umwandlung thermischer Energie eines Abgases in elektrische Energie gemeint, also ein sogenannter thermoelektrischer Generator.

Abgas aus einem Motor eines Kraftfahrzeugs besitzt thermische Energie, welche mittels eines thermoelektrischen Generators in elektrische Energie umgewandelt werden soll, um beispielsweise eine Batterie oder einen anderen Energiespeicher zu füllen und/oder elektrischen Verbrauchern die benötigte Energie direkt zuzuführen. Damit steht für den Betrieb des Kraftfahrzeugs Energie in größerem Umfang zur Verfügung.

Ein solcher thermoelektrischer Generator weist zumeist eine Mehrzahl thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des Seebeck-Effekts und ein Phänomen, welches mit Wärmeadsorbtion einhergeht und in Relation zu einem Stromfluss durch unterschiedliche Materialien verursacht wird. Der Peltier-Effekt ist beispielsweise zum thermoelektrischen Kühlen bereits vorgeschlagen worden.

Solche thermoelektrischen Wandlerelemente weisen bevorzugt eine Vielzahl von thermoelektrischen Elementen auf, die zwischen einer so genannten "Warmseite" und einer so genannten "Kaltseite" positioniert sind. Thermoelektrische Elemente umfassen z. B. wenigstens 2 Halbleiterquader (p- und n-dotiert), die auf ihrer Ober- und Unterseite (hin zur "heißen Seite" bzw. "kalten Seite") wechselseitig mit elektrisch leitenden Brücken verbunden sind. Keramikplatten bzw. Keramikbeschichtungen und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich ein Spannungspotential. Auf der einen Kontaktstelle wird dabei Wärme aufgenommen ("Warmseite"), wobei die Elektronen der einen Seite auf das energetisch höher liegende Leitungsband des folgenden Quaders gelangen. Auf der anderen Seite können die Elektronen nun Energie freisetzen, um wieder auf die andere Seite mit niedrigerem Energieniveau zu gelangen ("Kaltseite"). Somit kann sich bei einem entsprechenden Temperaturgefälle ein Stromfluss einstellen.

Es ist bereits versucht worden, entsprechende thermoelektrische Generatoren für die Anwendung in Kraftfahrzeugen, insbesondere Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden. Das Dokument US 2005/217714 beschreibt eine Vorrichtung zur Erzeugung elektrischer Energie aus einem Abgas einer Verbrennungskraftmaschine gemäss dem Oberbegrif des Anspruchs 1. Aufgabe der vorliegenden Erfindung ist es demnach, die mit Bezug auf den Stand der Technik geschilderten Probleme zumindest teilweise zu lösen. Insbesondere soll ein thermoelektrischer Generator angegeben werden, der einen verbesserten Wirkungsgrad hinsichtlich der Umwandlung von bereitgestellter thermischer Energie in elektrische Energie ermöglicht und insbesondere auch den wechselnden Beanspruchungen im Abgassystem mobiler Verbrennungskraftmaschinen gewachsen ist.

Diese Aufgaben werden mit einer Vorrichtung gemäß den Merkmalen des Patentanspruchs 1 gelöst. Vorteilhafte Ausgestaltungen der erfindungsgemäßen Vorrichtung sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die erfindungsgemäße Vorrichtung zur Erzeugung elektrischer Energie aus einem Abgas einer Verbrennungskraftmaschine umfasst die Merkmale des Anspruchs 1. Bei dieser Vorrichtung handelt es sich insbesondere um einen sogenannten thermoelektrischen Generator. Der Abgaseintritt und der Abgasaustritt können insbesondere als Teil einer Abgasanlage oder eines Abgasrohres ausgeführt sein. Es ist aber auch möglich, dass mehrere Abgaseintritte und/oder mehrere Abgasaustritte vorgesehen sind. Kernstück des Generators ist der Wärmeaustauschabschnitt. Damit ist insbesondere ein Teil des Strömungsweges des Abgases durch den Generator gemeint, in dem das Abgas thermische Energie an die Wärmeaustauschaggregate abgibt. Es ist möglich, dass das Abgas auf dem Weg durch den Generator mehrerer solcher Wärmeaustauschabschnitte durchläuft, bevorzugt ist jedoch die Variante, bei dem das Abgas nur einen (zusammenhängenden) Wärmeaustauschabschnitt durchläuft.

Um nunmehr für den Wärmeaustausch möglichst große Kontaktflächen zu bieten, wird eine Aufteilung der Abgasströmung in Strömungspfade und insbesondere kleine Kanäle bewerkstelligt. Strömungspfade können gerichtete und/oder ungerichtete Durchlässe für das Abgas bilden, z. B. infolge einer regelmäßigen und/oder unregelmäßigen Aufteilung des Abgases innerhalb des Wärmeaustauschabschnitts, wobei generell möglich ist, dass sich diese Abgasteilströmungen innerhalb des Wärmeaustauschabschnitts wieder (mehrfach) miteinander mischen (können).

Die Strömungspfade sind bevorzugt klar voneinander abgetrennt (z. B. durch eine fortlaufende Kanalwand). Bei Strömungspfaden und/oder Kanälen kann es aber in besonderen Fällen auch möglich sein, dass die Strömungspfade bzw. Kanäle miteinander über Verbindungskanäle und/oder Öffnungen kommunizieren können. Die Anzahl der Strömungspfade bzw. Kanäle beträgt bevorzugt deutlich mehr als 20, so zum Beispiel mindestens 50 oder sogar mindestens 100 Kanäle. Damit haben die Kanäle einen Öffnungsquerschnitt, der gegenüber dem des Abgaseintritts deutlich verkleinert ist, so dass eine deutlich vergrößerte Wärmeaustauschfläche, die von den Wänden der Strömungspfade/Kanäle gebildet werden, zur Verfügung steht.

Benachbart zu den Strömungspfaden sind bevorzugt ein oder zwei Wärmeaustauschaggregate mit den thermoelektrischen Elementen und der Kühleinrichtung angeordnet. Bevorzugt ist gegebenenfalls, dass die Kanäle an den Wärmeaustauschaggregaten anliegen, also in Wärme leitendem Kontakt sind. Die thermoelektrischen Elemente sind dabei bevorzugt entlang der Kanäle angeordnet, wobei ganz besonders bevorzugt ist, jeweils mehrere thermoelektrische Elemente unterschiedlicher Art über die Länge eines Strömungspfads im Wärmeaustauschabschnitt zu positionieren. Die Kühleinrichtung ist auf der Seite der thermoelektrischen Elemente angeordnet, die den Strömungspfaden abgewandt ist. Dabei sind die thermoelektrischen Elemente mit der Kühleinrichtung insbesondere unverlierbar verbunden. Das bedeutet insbesondere, dass die thermoelektrischen Elemente nur mit der Kühleinrichtung bzw. einem Teil der Wärmeaustauschaggregate stoffschlüssig verbunden ist. Der Wärme leitende Kontakt hin zu den Strömungspfaden erfolgt daher insbesondere nur über einen Anlagekontakt ohne stoffliche Verbindung. "Unverlierbar" soll in diesem Zusammenhang bedeuten, dass eine Relativbewegung der thermoelektrischen Elemente gegenüber der Kühleinrichtung (ohne Demontage) während des Betriebs der Vorrichtung nicht möglich ist, also die thermoelektrischen Elemente mit der Kühleinrichtung bzw. dem Wärmeaustauschaggregat verschweißt, verlötet, verklebt, verankert, verschraubt, verspannt oder in einer sonstigen Weise sicher befestigt sind, wobei gleichzeitig ein großflächiger Kontakt zwischen thermoelektrischen Elementen und Kühleinrichtung gewährleistet ist, der die Wärmeleitung zwischen diesen beiden nicht behindert.

Gemäß einer bevorzugten Weiterbildung der Vorrichtung sind Abgaseintritt und Abgasaustritt gegenüberliegend und die Wärmeaustauschaggregate radial dazu angeordnet. Damit können Abgaseintrittsstutzen und Abgasaustrittsstutzen beispielsweise in eine gradlinige, rohrförmige Abgasleitung integriert werden. Die Wärmeaustauschaggregate sind darum radial und senkrecht zu der Abgasleitung angeordnet, so dass das Abgas für die Erzeugung elektrischer Energie aus der Hauptströmungsrichtung radial umgelenkt werden muss, den Wärmeaustauschabschnitt durchtritt und danach wieder ein- und/oder mehrfach umgelenkt werden muss, um in Hauptströmungsrichtung durch den Abgasaustritt wieder abzuströmen. Damit lässt sich einerseits ein besonders kompakter Aufbau verwirklichen, außerdem erhöht die Umlenkung eine Turbulenzströmung des Abgases, so dass im nachfolgenden Wärmeaustauschabschnitt eine besonders innige Kontaktierung der Wände der Kanäle und damit ein guter Wärmeübergang hin zu den thermoelektrischen Elementen gewährleistet ist.

Darüber hinaus wird als vorteilhaft angesehen, dass die Wärmeaustauschaggregate und die Kühleinrichtung mit Plattenelementen ausgebildet sind, auf denen die thermoelektrischen Elemente positioniert sind. So können die Kühlkanäle, durch die beispielsweise eine Kühlflüssigkeit hindurchgeleitet wird, zwischen zwei aufeinander gesetzten Plattenelementen ausgebildet sein. Die Kühleinrichtung bzw. die Wärmeaustauschaggregate sind damit relativ stabil und robust, so dass insbesondere ein Austritt der Kühlflüssigkeit verhindert wird. Damit bieten aber die Plattenelemente auch die Möglichkeit der Anbindung der thermoelektrischen Elemente, die bevorzugt auf einer Seite eines Plattenelementes ausgebildet sind, die der Kühleinrichtung abgewandt ist. Damit ist das thermoelektrische Element beispielweise auf der Oberfläche eines Plattenelementes angeordnet, an dem dann auch die Kanäle für die Abgasströmung angeordnet sind. Die Plattenelemente können als Module bereitgestellt und für eine einfache Montage in der gewünschten Form zusammengestellt werden. Damit lässt sich eine relativ kostengünstige Herstellung eines solchen thermoelektrischen Generators verwirklichen.

Insoweit ist es hier besonders vorteilhaft, dass ein solches Plattenelement mit einer internen Kühleinrichtung und thermoelektrischen Elementen an beiden Seiten hin zu den benachbarten Strömungspfaden ausgeführt ist. Die interne Kühleinrichtung kann durch gefräste oder gebohrte oder in sonstiger Weise hergestellter Kühlkanäle gebildet sein, wobei gegebenenfalls (aber nicht bevorzugt) ein zusätzliches Material in die Kanäle eingebracht sein kann. Vorteilhaft ist aber, dass die Plattenelemente selbst aus sehr gut Wärme leitenden Materialien gebildet sind, so dass ein möglichst guter Übergang der erzeugten Wärmeenergie vom Abgas auf die Wärmeaustauschaggregate und damit in die thermoelektrischen Elemente gewährleistet wird. Darüber hinaus bieten diese Plattenelemente die Möglichkeit, die elektrischen Leitungen hin zu thermoelektrischen Elementen stabil und geschützt anzuordnen.

In diesem Zusammenhang wird auch vorgeschlagen, dass das Plattenelement mit einer Metallfolie gebildet ist, die mit thermoelektrischen Elementen versehen und mit einer Schutzschicht überdeckt ist. Die Metallfolie weist dabei gegebenenfalls eine Struktur auf, so dass ein Stapel aus zumindest zwei Metallfolien zwischen sich Kanäle, insbesondere für die Kühlflüssigkeit, bildet. Damit hat das Plattenelement eine geringe thermische Masse und ist sehr leicht. Für eine unverlierbare Verbindung zwischen thermoelektrischen Elementen und der Metallfolie sorgt zudem eine Schutzschicht, die insbesondere den Kontakt von Abgas auf deren Oberseite mit den bedeckten thermoelektrischen Elementen verhindert. Die Schutzschicht kann als Beschichtung und/oder als separates Bauteil ausgeführt sein (wie z. B. eine weitere metallische Folie).

Die durch die Stapelung von Plattenelementen erzeugbaren Kanäle, die von Abgas durchströmt werden, können ebenfalls durch strukturierte Metallfolien erzeugt werden. Dabei können mehrere Metallfolien aufeinander angeordnet sein, so dass auch Kanäle vorgesehen sein können, die nicht benachbart zu thermoelektrischen Elementen angeordnet sind.

Die eingesetzten thermoelektrischen Elemente können sich beispielsweise hinsichtlich ihrer Art nach wenigstens einem der folgenden Charakteristika unterscheiden: Aufbau, Material, Größe, elektrische Verschaltung, Kontaktfläche, etc. Die Verwendung unterschiedlicher Arten von thermoelektrischen Elementen über die Länge der Strömungspfade erlaubt eine gezieltere und effektivere Ausnutzung der thermischen Energie des hindurchströmenden Abgases.

Die alternativ oder kumulativ vorgeschlagene Ausgestaltung mit mindestens einem Element zur Strömungsbeeinflussung hat die Funktion, die Wärmeleitung vom hindurchströmenden Abgas zu den thermoelektrischen Elementen zu verbessern. Das Element kann ein zusätzliches Bauteil und/oder ein Teil der Wand des Strömungspfades sein. Insbesondere soll so (lastabhängig und/oder temperaturabhängig und/oder positionsabhängig) der Kontakt von Abgas zur Wandung des Strömungspfades beeinflusst werden.

Mit thermoelektrischen Elementen unterschiedlicher Art sind insbesondere Elemente mit unterschiedlichem Wirkungsgrad bzw. mit unterschiedlichem Wirkungsgradmaximum bezeichnet. Dabei weist der Wirkungsgrad eines Elementes einer Art hinsichtlicht der Umwandlung von thermischer zu elektrischer Energie zumindest ein Maximum in Bezug auf eine durchschnittliche Abgastemperatur auf. Diese thermoelektrischen Elemente werden bevorzugt hinsichtlich ihres unterschiedlichen Wirkungsgrades in einem ersten Abschnitt oder in zumindest einem zweiten Abschnitt eines Strömungspfades angeordnet. Die Abschnitte bezeichnen insbesondere Bereiche der Strömungspfade des Abgases durch den Generator mit unterschiedlicher durchschnittlicher Abgastemperatur. Die thermoelektrischen Elemente mit unterschiedlichen Wirkungsgradmaxima sind dementsprechend so anzuordnen, dass die jeweiligen Wirkungsgradmaxima auf die jeweils durchschnittlich vorherrschende Abgastemperatur in dem jeweiligen Abschnitt des Strömungspfades angepasst sind. Dementsprechend sind im Bereich des Abgaseintritts thermoelektrische Elemente vorzusehen, die ein Wirkungsgradmaximum im Bereich höherer Temperaturen aufweisen und entsprechend in der Nähe des Abgasaustritts des Wärmetauschabschnittes thermoelektrische Elemente, die bei vergleichsweise niedrigeren Temperaturen ihr Wirkungsgradmaximum aufweisen. Dadurch wird eine verbesserte Umsetzung der verfügbaren Wärmeenergie in elektrische Energie ermöglicht.

Neben einer Anordnung der thermoelektrischen Elemente in Strömungsrichtung des Abgases hintereinander, können diese je nach durchschnittlich vorherrschender Temperatur im Strömungspfad in entsprechenden Anordnungen aufgebaut sein. Dazu ist der zumindest eine Strömungspfad in zumindest einen ersten Abschnitt und zumindest einen weiteren zweiten Abschnitt aufgeteilt, in dem die thermoelektrischen Elemente mit jeweils gleichem Wirkungsgradmaximum angeordnet sind.

Gemäß einer weiteren vorteilhaften Ausführungsform der Vorrichtung weist zumindest ein Strömungspfad Leitschaufeln und/oder Wärmeleitstrukturen auf. Dadurch soll erreicht werden, dass eine möglichst große Menge an Wärmeenergie aus dem Abgas hin zu den thermoelektrischen Elementen geführt wird. Leitschaufeln können insbesondere dazu dienen, dass Abgas aus einem wandfernen Bereich des Strömungspfades zu den Oberflächen des Kanals abgelenkt wird, die mit den thermoelektrischen Elementen unmittelbar in Wärme leitender Verbindung stehen. Leitschaufeln weisen insbesondere eine Oberfläche auf, die in den Strömungspfad hineinragt und geeignet ist, zumindest einen Teil von dem durch den Strömungspfad strömenden Abgas hin zu den thermoelektrischen Elementen umzulenken. Diese Weiterbildung (und die strömungstechnisch nachfolgend angesprochenen) betrifft insbesondere die Ausgestaltung der Vorrichtung, die mit gleichartigen thermoelektrischen Elementen ausgeführt ist und nur mit Elementen zur Strömungsbeeinflussung versehen ist. Somit dienen die Leitschaufeln und/oder Wärmeleitstrukturen dazu, (lastabhängig und/oder temperaturabhängig und/oder positionsabhängig) den Kontakt vom Abgas zur Wandung des Strömungspfades gezielt zu beeinflussen.

Die Wärmeleitstrukturen sind insbesondere metallische Wärmeleitstrukturen, die sich zumindest über einen Teil der Länge eines Strömungspfades erstrecken, in diesen hineinragen und nur einen sehr geringen Strömungswiderstand gegenüber dem Abgasstrom aufweisen. Die Wärmeleitstrukturen sind daher bevorzugt dünn und großflächig ausgeführt, insbesondere in der Art einer Kühlrippe. Damit ermöglichen sie die Aufnahme von Wärme aus dem gesamten vom Abgas durchströmten Querschnitt eines Strömungspfades. Die Wärmeleitstrukturen sind mit einer hohen Wärmeleitfähigkeit auszuführen, so dass eine Abführung der aus dem Abgas übernommenen Wärmeenergie hin zu den thermoelektrischen Elementen ermöglicht wird.

Die Wärmeleitstrukturen sind dabei insbesondere in den stromabwärts gelegenen Abschnitten der Strömungspfade angeordnet, so dass in Bereichen "kälteren" Abgases die vorhandene Restwärme des Abgases zu einem größeren Teil aus dem Abgasstrom abgeführt werden kann. Gleichzeitig wird so ein Überhitzen der thermoelektrischen Elemente verhindert, die in Bereichen "heißeren" Abgases, also unmittelbar stromabwärts von dem Abgaseintritt des Generators, angeordnet sind. Gerade hier treten Temperaturspitzen des Abgases auf, die bei spezifischen Betriebspunkten der Verbrennungskraftmaschine so hoch ausfallen können, dass eine Schädigung der thermoelektrischen Elemente möglich ist. Eine zusätzliche Ableitung von Wärmeenergie aus dem heißen Abgas hin zu den thermoelektrischen Elementen erhöht somit die Wahrscheinlichkeit der Schädigung. In den weiter stromabwärts gelegenen Abschnitten ist das Abgas bereits soweit abgekühlt, dass eine Schädigung durch Temperaturspitzen sicher vermieden werden kann.

Insbesondere sind Strukturen vorzusehen, die die Funktion von Leitschaufeln, die das Abgas zumindest teilweise umlenken, und die Funktion von Wärmeleitstrukturen, die die Wärme aus dem Abgas durch große Kontaktflächen und gute Wärmeleitungseigenschaften hin zu den thermoelektrischen Elementen abführt, in einer Struktur kombinieren.

Gemäß einer weiteren vorteilhaften Ausführungsform der Vorrichtung weist zumindest ein Strömungspfad Strukturen und/oder Profilierungen an ersten Wandungen des Strömungspfades auf. Profilierungen bzw. Strukturen sollen insbesondere laminare Randströmungen des Abgases innerhalb des Strömungspfades verhindern bzw. reduzieren, so dass einerseits in Folge von derart erzeugten Turbulenzen wandfernes Abgas den ersten Wandungen zugeführt wird und somit ein höherer Anteil an Wärmeenergie aus dem Abgas abgeführt werden kann. Des weiteren soll durch die Strukturen und/oder Profilierungen der Staudruck des Abgases innerhalb des Strömungspfades erhöht werden, so dass infolge der dadurch erzeugten Verwirbelungen und der erzwungenen längeren Aufenthaltszeit des Abgases innerhalb des Strömungspfades ein besserer Wärmeübergang vom Abgas hin zu den thermoelektrischen Elementen erreicht wird. Mit ersten Wandungen sind hier Oberflächen der Strömungspfade/Kanäle bezeichnet, die selbst unmittelbar in wärmeleitender Verbindung mit den thermoelektrischen Elementen stehen. Als Strukturen sind insbesondere Oberflächen bezeichnet, die durch Einschnitte in die Wandungen der Strömungspfade erzeugt wurden und in die Strömungspfade hineinragen. Dagegen sind mit Profilierungen Oberflächen der Strömungspfade bezeichnet, die mit einem geschlossenen Oberflächenbereich der Wandungen der Strömungspfade gebildet werden, z. B. Noppen, Hügel, Erhebungen, Knicke, Wellen.

Die Strukturen und Profilierungen sind dabei insbesondere in den stromabwärts gelegenen Abschnitten der Strömungspfade angeordnet, so dass in Bereichen "kälteren" Abgases die vorhandene Restwärme des Abgases, durch Erzeugung von Turbulenzen und durch Verhinderung von laminaren Randströmungen, zu einem größeren Teil aus dem Abgasstrom abgeführt werden kann. Gleichzeitig wird so ein Überhitzen der thermoelektrischen Elemente verhindert, die in Bereichen "heißeren" Abgases, also unmittelbar stromabwärts von dem Abgaseintritt des Generators, angeordnet sind.

Gemäß einer besonders vorteilhaften Ausführungsform der Vorrichtung wird mit zunehmendem Staudruck das Abgas innerhalb zumindest eines Strömungspfades zumindest teilweise in einen benachbarten Bypassströmungspfad überführt.

Hierdurch wird insbesondere erreicht, dass eine Überlastung der thermoelektrischen Elemente durch zu hohe Abgastemperaturen vermieden ist. Dabei wird zumindest ein Teil des in einem Strömungspfad vorhandenen Abgases mit zunehmendem Druck und/oder ab einem spezifischen, voreinstellbaren Druck in zunehmenden Maße in einen benachbarten, bevorzugt im Wesentlichen parallelen, Strömungspfad überführt, der insbesondere nicht in unmittelbarem Kontakt mit thermoelektrischen Elementen steht. Somit wird erreicht, dass im Strömungspfad benachbart zu den thermoelektrischen Elementen eine Abgastemperatur vorliegt, die dem Wirkungsgradmaximum der thermoelektrischen Elemente entspricht. Der benachbarte Bypassströmungspfad ist insbesondere durch zweite Wandungen von dem Strömungspfad getrennt, der unmittelbar mit den thermoelektrischen Elementen in Wärme leitendem Kontakt steht. Diese zweiten Wandungen sind also nicht unmittelbar mit den thermoelektrischen Elementen in wärmeleitendem Kontakt. Die zweiten Wandungen sind insbesondere zumindest teilweise mit Öffnungen versehen, so dass eine Überführung des Abgases aus dem Strömungspfad in den Bypassströmungspfad möglich ist.

Im Hinblick auf die vorstehenden Ausführungen betrifft die Erfindung folglich auch eine Vorrichtung zur Erzeugung elektrischer Energie aus einem Abgas einer Verbrennungskraftmaschine, umfassend einen Generator mit einem Abgaseintritt und einem Abgasaustritt und einem Wärmeaustauschabschnitt dazwischen, wobei der Wärmeaustauschabschnitt eine Vielzahl von Strömungspfaden für das Abgas aufweist, wobei die Strömungspfade zumindest teilweise von thermoelektrischen Elementen umgeben sind, die auf der dem Strömungspfad abgewandten Seite mit einer Kühleinrichtung in wärmeleitender Verbindung stehen, bei der mindestens ein Bypass-Strömungspfad vorgesehen ist, wobei mit zunehmendem Staudruck das Abgas innerhalb zumindest eines Strömungspfades zumindest teilweise in einen benachbarten Bypass-Strömungspfad überführt wird. Da hiermit auch separat eine Verbesserung gegenüber dem Stand der Technik erreicht wird, kann dieses Konzept auch unabhängig weiterverfolgt werden. Weiterbildungen dieses Konzeptes können den nachfolgenden Erläuterungen (insbesondere den nachfolgenden zwei Absätzen und den Darstellungen des selbstregulierenden Überlastschutz-Verfahrens) entnommen werden.

Gemäß einer besonders vorteilhaften Ausführungsform ist der Bypassströmungspfad durch einen in dem Strömungspfad angeordneten Körper mit einer offenen Grundfläche gebildet, der sich entgegen der Strömungsrichtung des Abgases innerhalb des Strömungspfades verjüngt und eine für das Abgas durchströmbare zweite Wandung aufweist. Der Körper kann insbesondere in Form eines Konus oder einer Schräge gestaltet sein. Dabei ist der Körper insbesondere aus dem gleichen Material wie die Wandungen bzw. die Oberfläche des Strömungspfades gebildet und ggf. sogar mit diesem einstückig, also formschlüssig oder auch kraftschlüssig, verbunden. Die den Körper bildende zweite Wandung ist also insbesondere nicht in Wärme leitendem Kontakt mit den thermoelektrischen Elementen, also zumindest zum größten Teil nicht im Kontakt mit ersten Wandungen, und innerhalb des Strömungspfades angeordnet.

Weiterhin ist die zweite Wandung des Körpers gasdurchlässig ausgeführt, so dass Abgas aus dem Strömungspfad in den Körper und dann zum Abgasaustritt gelangen kann. Bei zunehmendem Staudruck des Abgases wird nun eine immer größer werdende Menge des Abgases bereits durch die ersten Öffnungen innerhalb der zweiten Wandung in den Körper eintreten und damit keine (oder nur in geringem Maße) Wärme an die ersten Wandungen des Strömungspfades abgeben, die in Kontakt mit den thermoelektrischen Elementen stehen. Der Körper bzw. der Bypassströmungspfad ist dabei so vorzusehen, dass sich die Öffnungen bevorzugt über die gesamte Länge des Strömungspfades erstrecken, so dass Abgas bereits aus den ersten Abschnitten des Strömungspfades in diesen Bypassströmungspfad bzw. in den Körper eintreten können, so dass eine Überhitzung insbesondere der im Bereich des Abgaseintritts angeordneten thermoelektrischen Elemente vermieden wird.

Außerdem kann auch vorgesehen sein, dass eine Zusatzkühlung für zumindest einen Teil des Wärmeaustauschabschnitts vorhanden ist. Das heißt beispielsweise, dass ein zweiter Kühlkreislauf bedarfsorientiert zugeschaltet werden kann. Ganz besonders bevorzugt ist die Zusatzkühlung eine Umkehr-Schaltung der thermoelektrischen Elemente, so dass diese als Peltier-Elemente wirken. Damit können sie dann den Wärmeaustauschabschnitt bzw. sich selbst kühlen für den Fall, dass zu heißes Abgas durch den thermoelektrischen Generator strömt.

Gemäß einer Weiterbildung ist die Vorrichtung mit zumindest einem Katalysatorabschnitt ausgeführt, der zumindest teilweise dem Wärmeaustauschabschnitt strömungstechnisch vorgelagert ist. Dabei ist ganz besonders bevorzugt, dass das Abgas, das in den Wärmeaustauschabschnitt gelenkt wird, zunächst über den Katalysatorabschnitt strömt und danach den Wärmeaustauschabschnitt erreicht. Ganz besonders bevorzugt ist, dass der Katalysatorabschnitt und der Wärmeaustauschabschnitt vom Abgas entgegengesetzt durchströmt werden. In dem Katalysatorabschnitt ist bevorzugt eine radiale Wabenstruktur vorgesehen. Die Wabenstruktur des Katalysatorabschnitts ist mit Washcoat und einem Oxidationskatalysator beschichtet (Platin bevorzugt). In dem Katalysatorabschnitt wird in Folge der katalytischen Umsetzung von Bestandteilen des Abgases eine exotherme Reaktion in Gang gesetzt, die die thermische Energie im Abgas erhöht. Dieses nun "vorgeheizte" Abgas dient nun zur Generierung einer größeren Menge thermoelektrischer Energie. Der Katalysatorabschnitt kann gegebenenfalls mit verschiedenen Beschichtungen und/oder Katalysatoren ausgeführt sein. Auch ist möglich, den Katalysatorabschnitt hinsichtlich des Kontaktbereich und/oder des zugeführten Abgases variabel zu gestalten, um so die Temperaturerhöhung gezielt zu regeln. Insbesondere können auch wenigstens Teilbereiche der Kanäle und Wandungen der vom Abgas durchströmten weiteren Bereiche des Generators, insbesondere wenigstens Teilbereiche der Kanäle des Wärmeaustauschabschnittes, mit Washcoat und einem Oxidationskatalysator beschichtet sein. Bevorzugt werden dabei erste Wandungen, also die Bereiche der Kanäle, die unmittelbar an ein thermoelektrisches Element angrenzen, nicht mit einer solchen Beschichtung versehen, da hierdurch die Wärmeleitfähigkeit von den Strömungspfaden zu den thermoelektrischen Elementen beeinträchtigt werden kann.

Gemäß einer weiteren vorteilhaften Ausführungsform ist der Oxidationskatalysator beheizbar. Dadurch wird erreicht, dass der Oxidationskatalysator besonders schnell seine light-off-Temperatur erreicht und somit eine katalytische Umsetzung des Abgases beginnt. Die Temperatur des Abgases wird somit schneller erhöht und damit auch der Wirkungsgrad des Generators.

Eine zusätzliche Weiterbildung sieht vor, dass stromabwärts von dem Wärmeaustauschabschnitt zumindest ein NOx-Speicher vorgesehen ist. Eine solche Anordnung ist insbesondere deshalb vorteilhaft, weil durch die Abführung einer großen Wärmemenge aus dem Abgas stromabwärts der Vorrichtung eine nur noch geringe Abgastemperatur vorliegt. Diese Temperatur liegt insbesondere für lange Zeiträume unterhalb einer Desorptionstemperatur des NOx-Speichers, so dass Stickoxide sicher aus dem Abgas entfernt und innerhalb der Abgasanlage umgesetzt werden können, z. B. durch SCR-Komponenten.

Die vorgenannten Aufgaben werden zudem durch ein Verfahren zur Erzeugung elektrischer Energie aus einem Abgas einer Verbrennungskraftmaschine gelöst durch eine Vorrichtung umfassend einen Generator mit einem Abgaseintritt und einem Abgasaustritt und einem Wärmetauschabschnitt dazwischen, wobei der Wärmeaustauschabschnitt eine Vielzahl von Strömungspfaden für das Abgas aufweist, wobei die Strömungspfade zumindest teilweise von thermoelektrischen Elementen umgeben sind, die auf der dem Strömungspfad abgewandten Seite mit einer Kühleinrichtung in wärmeleitender Verbindung stehen, wobei der wärmeleitende Kontakt des Abgases mit den thermoelektrischen Elementen zumindest in Abhängigkeit des Gesamtmassenstroms oder der Temperatur des Abgases geregelt wird.

Gemäß einer besonders vorteilhaften Ausführungsform des Verfahrens erfolgt die Regelung des wärmeleitenden Kontakts des Abgases mit den thermoelektrischen Elementen zumindest in Abhängigkeit des Gesamtmassenstroms oder der Temperatur des Abgases selbstregulierend.

Die Regelung des wärmeleitenden Kontakts wird insbesondere durch einen Überlastschutz realisiert, der insbesondere für alle Strömungspfade vorgesehen ist, die mit thermoelektrischen Elementen über erste Wandungen unmittelbar wärmeleitend verbunden sind. Dieser selbstregulierende Überlastschutz ist insbesondere durch einen Bypass-Strömungspfad realisiert, der benachbart und insbesondere im Wesentlichen parallel zu dem Strömungspfad angeordnet ist und insbesondere innerhalb des Strömungspfades vorgesehen ist. Dabei strömt durch den zumindest einen Strömungspfad mit Überlastschutz jeweils nur ein sehr geringer Teil des vorhandenen Abgasstromes, der durch den Abgaseintritt in die Vorrichtung eingetreten ist, hindurch. Insbesondere ist dieser Strömungspfad so ausgelegt, dass nur maximal 5 Vol.-%, bevorzugt maximal 1 Vol.-%, besonders bevorzugt maximal 0,1 Vol.-% des Abgasstromes, der in die Vorrichtung durch den Abgaseintritt hineinströmt, durch diesen hindurch strömt.

Gemäß einer weiteren vorteilhaften Ausführungsform weist das Verfahren einen selbstregulierenden Überlastschutz auf, der in Abhängigkeit des Staudrucks des Abgases eine strömungstechnische Abtrennung einer größer werdenden Menge an Abgas von ersten Wandungen eines Strömungspfades vorsieht. Dabei ist der selbstregulierende Überlastschutz derart ausgelegt, dass bei steigendem Staudruck kontinuierlich eine größer werdende Menge an Abgas nicht die ersten Wandungen eines Strömungspfades kontaktiert, sondern insbesondere in einen benachbarten Bypassströmungspfad eintritt, der nicht unmittelbar mit den thermoelektrischen Elementen in wärmeleitender Bindung steht.

In einer weiteren Ausführungsform ist der selbstregulierende Überlastschutz derart ausgelegt, dass erst ab einem gewissen Staudruckniveau eine strömungstechnische Abtrennung einer größer werdenden Menge an Abgas von ersten Wandungen eines Strömungspfades vorgenommen wird.

Die Verfahren zum Überlastschutz finden gerade bei einer Vorrichtung Anwendung, die einen Bypass-Strömungspfad aufweist, wie dies in dem selbstständigen Konzept oben dargestellt wurde.

Die Erfindung findet ganz besonders bevorzugt Anwendung in einem Kraftfahrzeug, insbesondere in einem Personenkraftfahrzeug mit einer Verbrennungskraftmaschine.

Die Erfindung sowie das technische Umfeld werden anhand der schematischen Figuren veranschaulicht. Es ist darauf hinzuweisen, dass die Figuren besonders bevorzugte Ausführungsvarianten zeigen, die Erfindung jedoch nicht darauf beschränkt ist. Es zeigen:
- Fig. 1:: schematisch die Integration der Vorrichtung in einem Kraftfahrzeug;
- Fig. 2:: ein Detail eines Wärmeaustauschaggregates;
- Fig. 3:: ein Beispiel einer Metallfolie zum Aufbau eines Wärmeaustauschabschnittes;
- Fig. 4:: den möglichen Aufbau für ein Wärmeaustauschaggregat in Explosionsdarstellung;
- Fig. 5:: ein Teilschnitt durch einen oberen Teil der Kühleinrichtung mit einem thermoelektrischen Element;
- Fig. 6:: einen Querschnitt durch einen Strömungspfad in einer Seitenansicht gemäß einer Ausgestaltung der Erfindung;
- Fig. 7:: einen Querschnitt durch einen Strömungspfad in einer Seitenansicht mit einem Bypassströmungspfad;
- Fig. 8:: einen Querschnitt durch einen Strömungspfad in einer Seitenansicht mit einer weiteren Ausgestaltung des Bypassströmungspfades; und
- Fig. 9:: eine grafische Darstellung der Abgasströme durch Strömungspfad und Bypass.

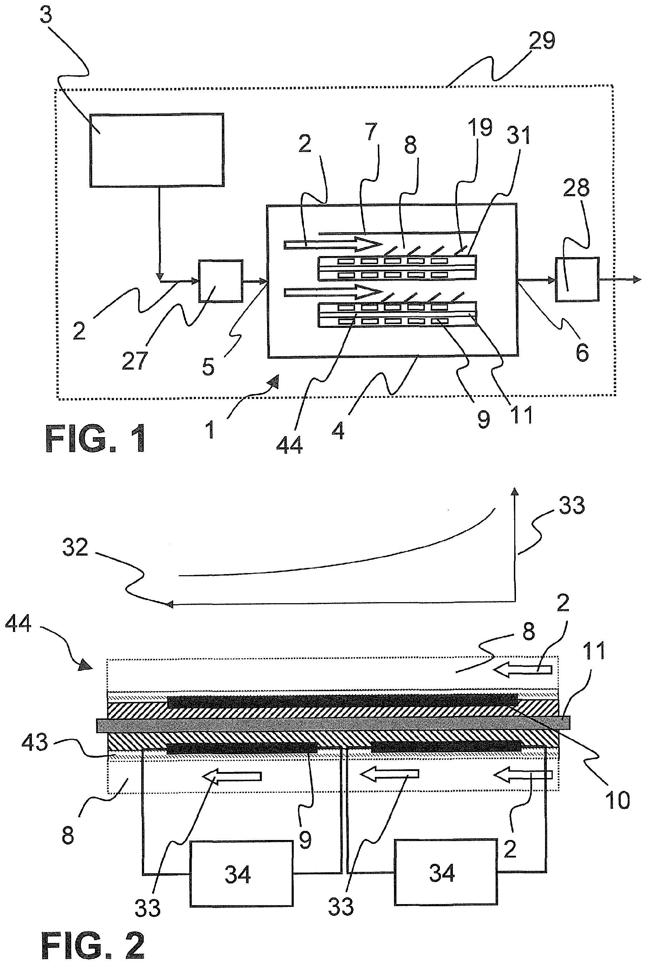

Fig. 1 veranschaulicht schematisch den bevorzugten Einsatzzweck einer solchen Vorrichtung 1. Dabei ist ein Kraftfahrzeug 29 mit einer Verbrennungskraftmaschine 3 gezeigt. Das in der Verbrennungskraftmaschine 3, bspw. einem OttoMotor oder einem Diesel-Motor, erzeugte Abgas 2 strömt zu den Abgasreinigungskomponenten 27, 28.

Die erfindungsgemäße Vorrichtung 1 ist der Verbrennungskraftmaschine 3 in vorteilhafter Weise direkt und unmittelbar nachgeschaltet oder in einem entsprechenden Abgasreinigungssystem angeordnet. Sie kann auch als Teil einer Abgasrückführung vorgesehen sein, bei der in vorteilhafter Weise auf einen Abgaskühler zurückgegriffen werden kann.

Gemäß einer vorteilhaften Ausgestaltung ist der Vorrichtung 1 ein Oxidationskatalysator 27 vorgeschaltet, der auch zumindest teilweise in der Vorrichtung 1 integriert sein kann. Der Vorrichtung 1 nachgeschaltet ist vorteilhafter Weise ein NOₓ-Speicher 28, der ebenfalls zumindest teilweise in die Vorrichtung 1 integriert sein kann. Die Vorrichtung 1 weist einen Abgaseintritt 5 auf, durch den das Abgas 2 in die Vorrichtung 1 einströmt. Der Generator 4 der Vorrichtung 1 wird dabei gebildet durch einen Wärmeaustauschabschnitt 7, der insbesondere aus einer Vielzahl von Wärmeaustauschaggregaten 44 mit thermoelektrischen Elementen 9 und zumindest einer Kühleinrichtung 11 aufgebaut ist, die zwischen den Strömungspfaden 8 vorgesehen sind, so dass die Wärmeenergie des Abgases 2 über Oberflächen 31 des Strömungspfades 8 zu den thermoelektrischen Elementen 9 geleitet werden kann, die infolge des Temperaturpotentials zwischen warmem Abgas 2 und Kühleinrichtung 11 einen elektrischen Strom erzeugen können. Innerhalb der Strömungspfade 8 sind bevorzugt Strukturen 19 angeordnet, die einerseits eine Verwirbelung des Abgases 2 erreichen, so dass der Wärmeübergang von dem Abgas 2 zu den Oberflächen 31 des Strömungspfades 8 verbessert wird. Das Abgas 2 verlässt den Generator 4 über den Abgasaustritt 6.

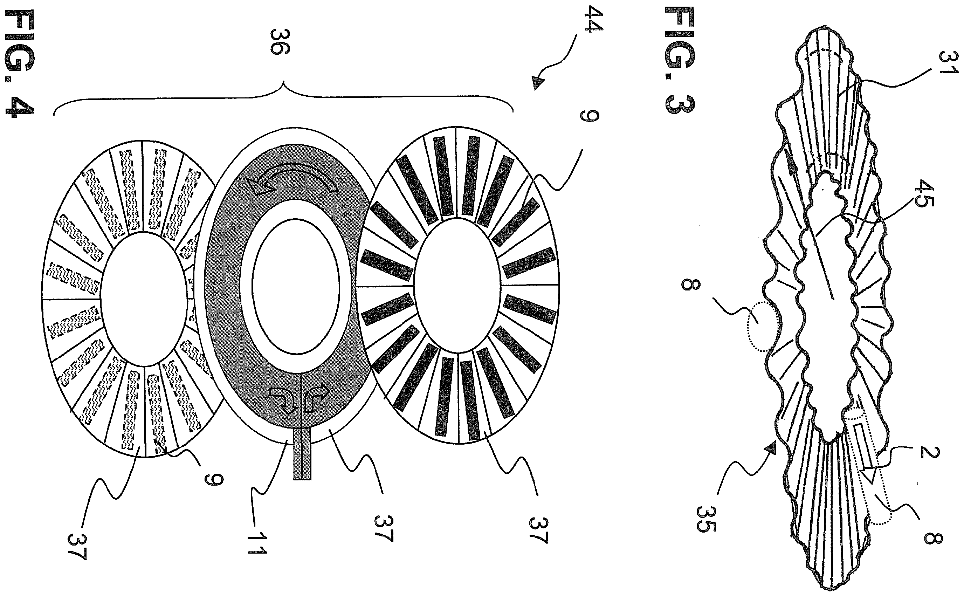

Fig. 2 veranschaulicht schematisch den Aufbau eines Wärmeaustauschaggregates 44. Das Wärmeaustauschaggregat 44 ist benachbart zu beidseits angeordneten Strömungspfaden 8 positioniert, die von heißem Abgas 2 durchströmt werden. Das Wärmeaustauschaggregat 44 umfasst eine interne Kühleinrichtung 11, wobei zwischen der Kühleinrichtung 11 und den Strömungspfaden 8 jeweils zumindest ein thermoelektrisches Element 9 vorgesehen ist. Oben in Fig. 3 ist zudem zur Erläuterung ein Diagramm dargestellt, welches die Abgastemperatur 33 über die Länge 32 des Strömungspfades 8 bzw. des zumindest einen thermoelektrischen Elementes 9 veranschaulicht. Die Temperatur auf der dem Strömungspfad 8 gegenüberliegenden Seite 10 des thermoelektrischen Elementes 9 ist aufgrund der Kühlmitteleinrichtung 11 deutlich geringer. Dies führt zum sogenannten Seebeck-Effekt, so dass vom thermoelektrischen Element 9 Strom abgegriffen werden kann, der einem Speicher 34 zugeführt wird. Um hier insbesondere den direkten Kontakt der thermoelektrischen Elemente 9 bzw. den Halbleiterelementen mit dem Abgas 2 zu vermeiden, ist eine Schutzschicht 43 vorgesehen.

Weiter ist zumindest in einem Strömungspfad 8 vorgesehen, dass mehrere thermoelektrische Elemente 9 unterschiedlicher Art in Strömungsrichtung hintereinander angeordnet sind, die hinsichtlich ihrer Wirkungsgrade in Bezug zu der jeweils durchschnittlich vorherrschenden Abgastemperatur 33 ausgewählt sind. Dabei sind in dem Bereich durchschnittlich höherer Abgastemperaturen (in Fig. 2 rechts im Bild) thermoelektrische Elemente 9 vorgesehen, die einen hohen Wirkungsgrad bei hohen Abgastemperaturen 33 aufweisen. Im linken Teil des gezeigten Strömungspfades 8 sind thermoelektrische Elemente 9 vorgesehen, die einen entsprechend hohen Wirkungsgrad bei niedrigeren Abgastemperaturen 33 aufweisen. Dementsprechend kann eine größtmögliche Menge an elektrischem Strom aus der Wärmeenergie des Abgases 2 gewonnen werden.

Fig. 3 zeigt ein Beispiel einer Metallfolie 35 zum Aufbau eines Wärmeaustauschabschnittes 7. Der Wärmeaustauschabschnitt 7 wird somit aus Metallfolien 35 gebildet, die aufeinander gestapelt sind und dementsprechend einen Radialwabenkörper ergeben, mit Strömungspfaden 8, die von innen nach außen laufen und dementsprechend von innen nach außen oder von außen nach innen für das Abgas 2 durchströmbar sind. Die Metallfolie 35 kann hier insbesondere zur Begrenzung der Strömungspfade 8 für das Abgas 2 und/oder der Kanäle für die Kühleinrichtung 11 herangezogen werden. Diese Metallfolie 35 weist eine zumindest teilweise strukturierte Oberfläche 31 auf, die in Umfangsrichtung der Metallfolie 35 abwechselnd Erhebungen und Senken aufweist, so dass in Richtung des Radius 45 verlaufende Kanäle gebildet sind. Die Kanäle können auch spiralförmig verlaufen, so dass in Richtung des Radius 45 einander abwechselnd Erhebungen und Senken auftreten. Stapelt man mehrere solcher Metallfolien 35 aufeinander, können die Strömungspfade 8 bzw. kann die Kühleinrichtung 11 dazwischen ausgeformt werden.

Fig. 4 zeigt schematisch in einer Explosionsdarstellung einen möglichen Aufbau eines Wärmeaustauschaggregates 44 in Form eines Plattenelementes 36. Dieses Plattenelement 36 umfasst eine obere Scheibe 37, die in Fig. 4 oben dargestellt ist. Dort ist bspw. eine radiale Anordnung der thermoelektrischen Elemente 9 vorgesehen, insbesondere bei gleichartiger Ausrichtung der Kanäle 8. Dazu weist das Wärmeaustauschaggregat 44 eine zentrale Scheibe 37 auf, in dem die Kühleinrichtung 11 ausgeformt ist. Hierzu strömt das Kühlmittel in die Kühleinrichtung 11 ein, umläuft die Scheibe 37 in Umfangsrichtung und strömt dann wieder ab. Gleichwohl können auch andere Strömungsrichtungen und/oder Strömungsaufteilungen des Kühlmittels realisiert werden. Unterhalb der zentralen Scheibe 37 ist eine weitere Scheibe 37 angeordnet, die wiederum thermoelektrische Elemente 9 aufweist, die hier nur gestrichelt dargestellt sind, da sie sich an der Unterseite der gezeigten Scheibe 37 befinden.

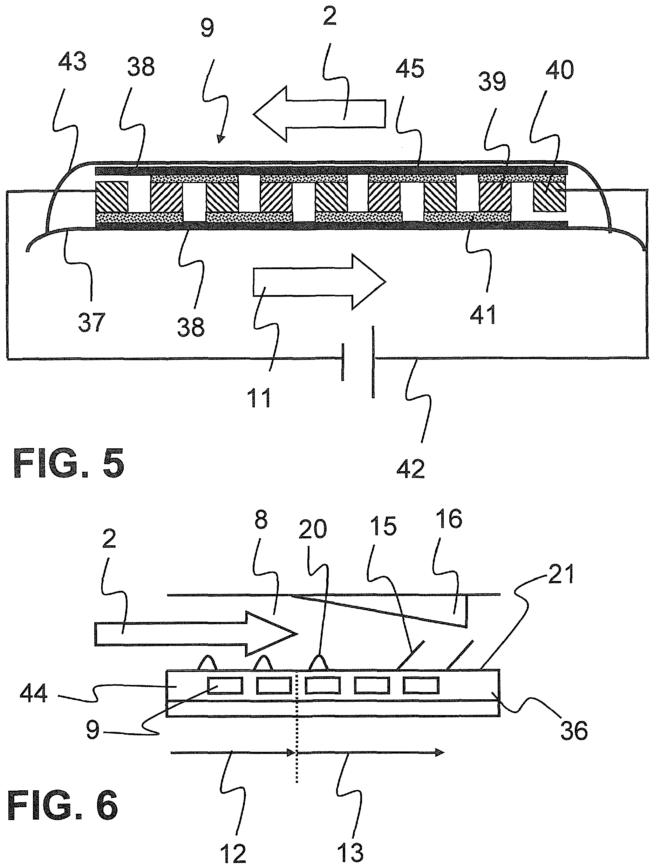

Fig. 5 veranschaulicht einen Teilschnitt durch einen oberen Teil der Kühleinrichtung 11 mit einem thermoelektrischen Element 9. Nur der Vollständigkeit halber sei darauf hingewiesen, dass (meist) mehrere thermoelektrische Elemente 9 bei einer Kühlvorrichtung 11 vorgesehen sind, die parallel und/oder in Serie elektrisch geschaltet sind. Ein thermoelektrisches Element 9 ist hier gasdicht und/oder abgedichtet gegenüber Flüssigkeiten zwischen einer Schutzschicht 43 und einer Scheibe 37 der Kühleinrichtung 11 angeordnet und stoffschlüssig mit der Scheibe 37 verbunden. Das thermoelektrische Element 9 umfasst mehrere paarweise Anordnungen von verschiedenen Halbleiterquadern (p-dotierte Halbleiterquader 40 und n-dotierte Halbleiterquader 39), die auf ihrer Ober- und Unterseite wechselseitig mit metallischen, elektrisch leitenden Brücken 41 verbunden sind. Die Brücken 41 sind auf Keramikplatten 38 angebracht, so dass ein gerichteter Stromfluss über die Brücken 41 gewährleistet ist. Strömt nun heißes Abgas 2 an der Schutzschicht 43 vorbei, heizt sich diese Seite auf, während die gegenüberliegende Seite durch das Kühlmittel gekühlt wird. Damit kann nun gemäß dem Seebeck-Effekt effektiv thermische Energie in elektrische Energie umgewandelt werden.

Fig. 6 zeigt schematisch in einer Seitenansicht ein Detail eines Strömungspfades 8 mit einem Wärmeaustauschaggregat 44. Dabei strömt das heiße Abgas 2 in den Strömungspfad 8 ein, wobei eventuell vorhandene laminare Randströmungen insbesondere durch Profilierungen 20 an einer ersten Wandung 21, die unmittelbar mit den thermoelektrischen Elementen 9 in wärmeleitender Verbindung stehen, aufgelöst werden. Weiter können auch Leitschaufeln 15 vorgesehen sein, die ebenfalls zur Erzeugung von Turbulenzen in dem Abgasstrom vorgesehen sind, um somit einen besseren Wärmeübergang vom Abgas 2 an die erste Wandung 21 zu ermöglichen. Zudem können insbesondere an ersten Wandungen 21 Wärmeleitstrukturen 16 vorgesehen sein, die eine zusätzliche Wärmekapazität aufweisen und somit erstens eine größtmögliche Menge an Wärmeenergie aus dem Abgas 2 abführen und an die ersten Wandungen 21 abgeben, und zweitens vorhandene Wärmeenergie aus dem Abgas 2 speichern und diese kontinuierlich und mit leichter zeitlicher Verzögerung an die ersten Wandungen 21 abgeben. Entlang des Strömungspfades 8 sind erste Abschnitte 12 und zumindest zweite Abschnitte 13 vorgesehen, innerhalb derer thermoelektrische Elemente 9 unterschiedlicher Arten in dem Plattenelement 36 vorgesehen sind. Dabei können mehrere thermoelektrische Elemente 9 gleicher Art hintereinander angeordnet sein.

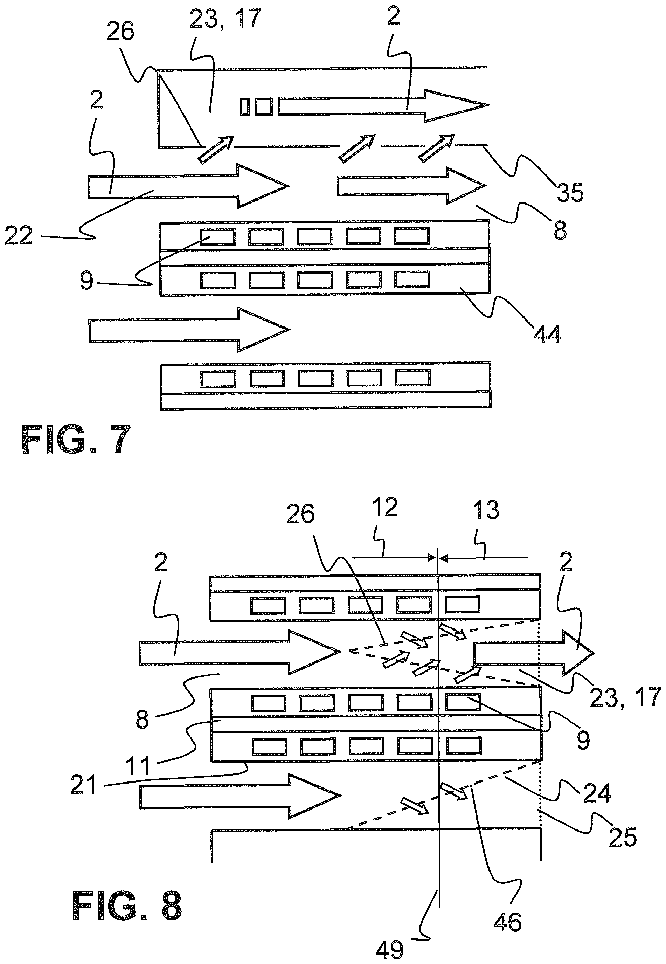

Fig. 7 zeigt schematisch in einer Seitenansicht einen Strömungspfad 8 mit einem Bypassströmungspfad 23 bzw. einem Überlastschutz 17, so dass die Wärmeaustauschaggregate 44 und insbesondere die thermoelektrischen Elemente 9 vor zu großen Temperaturen des Abgases 2 geschützt sind. Das Abgas 2 strömt in die Strömungspfade 8 ein, wobei bei zunehmendem Staudruck 22 eine größer werdende Menge Abgas 2 über eine zweite Wandung 26, die insbesondere durch eine Metallfolie 35 gebildet wird, in einen benachbarten Strömungskanal überführt wird. Dabei können Strömungspfade 8 über ihre Erstreckung auch konisch ausgeführt sein (hier nicht dargestellt), sich also insbesondere in Abgasströmungsrichtung verengen. Dadurch wird insbesondere erreicht, dass bei steigendem Staudruck 22 des Abgases 2 eine größer werdende Menge Abgas 2 über eine vorhandene Porosität in einer zweiten Wandung 26 in den benachbarte Überlastschutz 17 bzw. den Bypassströmungspfad 23 überführt wird. Insbesondere ist der Bypassströmungspfad 23 zwischen mehreren Strömungspfaden 8 angeordnet, so dass über zweite Wandungen 26 aus mehreren Strömungspfaden 8 Abgas 2 in den Bypassströmungspfad 23 einströmen kann. Daher kann der Bypassströmungspfad 23 insbesondere auch andere, also auch größere, Querschnitte aufweisen als die Strömungspfade 8.

Fig. 8 zeigt schematisch eine weitere vorteilhafte Ausgestaltung eines Überlastschutzes 17 bzw. eines Bypassströmungspfades 23, der innerhalb eines Strömungspfades 8 vorgesehen ist. Dabei ist innerhalb des Strömungspfades 8 insbesondere ein Körper 24 vorgesehen, der sich entgegen der Abgasströmungsrichtung innerhalb des Strömungspfades 8 verjüngt. Im oberen Teil der Fig. 8 ist der Körper 24 konusartig dargestellt. Im unteren Teil der Fig. 8 wird der Körper 24 durch eine Schräge gebildet, die sich ausgehend von der ersten Wandung 21 entgegen der Strömungsrichtung 14 des Abgases 2 erstreckt. Der Körper 24 wird durch eine zweite Wandung 26 gebildet, die perforiert ausgeführt ist, so dass Abgas 2 durch sie hindurchströmen kann. Die Grundfläche 25 des Körpers 24 ist offen ausgeführt, so dass das Abgas 2 über die Grundfläche 25 aus dem Strömungspfad 8 abströmen kann. Bei steigendem Staudruck 22 wird das Abgas 2 innerhalb des Strömungspfades 8 insbesondere über die gesamte zweite Wandung 26 in den Körper 24 einströmen, während bei geringem Staudruck 22 das Abgas 2 bis zum Ende des Strömungspfades 8 entlang der zweiten Wandung 26 strömt und die Wärmeenergie des Abgases 2 insbesondere über die erste Wandung 21 des Strömungspfades 8 über die thermoelektrischen Elemente 9 zur Kühleinrichtung 11 abgeführt wird. Bei hohem Staudruck 22 strömt das Abgas 2 also insbesondere auch schon in einem ersten Abschnitt 12 des Strömungspfades 8 durch die zweite Wandung 26 in den Bypassströmungspfad 23 und kontaktiert damit nicht mehr die ersten Wandungen 21. Bei niedrigem Staudruck 22 wird das Abgas 2 erst durch insbesondere größere Öffnungen 46 der zweiten Wandung 26 in dem zweiten Abschnitt 13 des Strömungspfades 8 in den Bypassströmungspfad 23 überströmen, so dass über die gesamte Länge des Strömungspfades 8 die größte Menge des Abgases 2 die ersten Wandungen 21 kontaktiert.

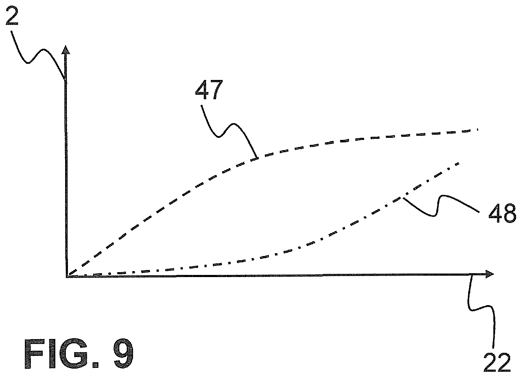

Fig. 9 veranschaulicht die jeweiligen Abgasströmungen durch den Strömungspfad/Kanal 8 einerseits und durch den Bypassströmungspfad 23 bzw. den Überlastschutz 17 andererseits. Dabei strömt die durch den Abgaseintritt 5 in die Vorrichtung 1 einströmende Menge Abgas 2 bevorzugt als Hauptabgasstrom 46 durch den Strömungspfad 8 und wird erst sukzessive in Abhängigkeit eines steigenden Staudrucks 22 durch eine zweite Wandung 26 hindurch treten und dann teilweise durch den Überlastschutz 17 bzw. den Bypassströmungspfad 23 als Bypassabgasstrom 48 abströmen.

Bei einer Ausgestaltung des Bypassströmungspfades 23 innerhalb des Strömungspfades 8, z. B. durch das Vorsehen eines Körpers 24 entsprechend Fig. 8, zeigt die Fig. 9 an der Koordinate 49 gemäß Fig. 8, dass auch hier mit zunehmendem Staudruck 22 eine zunehmend größere Menge Abgas 2 bereits an der Koordinate 49 die zweite Wandung 26 durchströmt hat und als Bypassabgasstrom 48 nicht mehr in unmittelbarem Kontakt zur ersten Wandung 21 steht.

Die vorliegende Erfindung beinhaltet zumindest drei Aspekte, die eine signifikante Weiterbildung des Standes der Technik zur Folge haben:
1. Konzepte zur Strömungsbeeinflussung, um den Wärmeübergang vom Abgas hin zu den thermoelektrischen Elementen gezielt einzustellen,
2. Konzepte zur Realisierung eines (selbstregulierenden) Bypass als Überlastschutz, und
3. Konzepte zur gezielten Auslegung der thermoelektrischen Elemente an (ungleiche) Strömungsbedingungen.

Auch wenn diese Konzepte hier teilweise im Zusammenhang miteinander erläutert wurden und tatsächlich synergetisch Vorteile zur Folge haben, kann auch eine separate Verwirklichung schon signifikante Verbesserungen gegenüber den bekannten Konstruktionen eines thermoelektrischen Generators darstellen.

### Bezugszeichenliste

- 1: Vorrichtung
- 2: Abgas
- 3: Verbrennungskraftmaschine
- 4: Generator
- 5: Abgaseintritt
- 6: Abgasaustritt
- 7: Wärmeaustauschabschnitt
- 8: Strömungspfad/Kanal
- 9: Thermoelektrisches Element
- 10: Seite
- 11: Kühleinrichtung
- 12: Erster Abschnitt
- 13: Zweiter Abschnitt
- 14: Strömungsrichtung
- 15: Leitschaufeln
- 16: Wärmeleitstrukturen
- 17: Überlastschutz
- 18: Randströmung
- 19: Struktur
- 20: Profilierung
- 21: Erste Wandung
- 22: Staudruck
- 23: Bypass-Strömungspfad
- 24: Körper
- 25: Grundfläche
- 26: Zweite Wandung
- 27: Oxidationskatalysator
- 28: NOx-Speicher
- 29: Kraftfahrzeug
- 30: Element zur Strömungsbeeinflussung
- 31: Oberfläche
- 32: Länge
- 33: Temperatur
- 34: Stromspeicher
- 35: Metallfolie
- 36: Plattenelement
- 37: Scheibe
- 38: Keramikplatte
- 39: N-dotierter Halbleiterquader
- 40: P-dotierter Halbleiterquader
- 41: Brücke
- 42: Strompfad
- 43: Schutzschicht
- 44: Wärmeaustauschaggregat
- 45: Radius
- 46: Öffnung
- 47: Hauptabgasstrom
- 48: Bypassabgasstrom
- 49: Koordinate

## Patentansprüche

1. Vorrichtung (1) zur Erzeugung elektrischer Energie aus einem Abgas (2) einer Verbrennungskraftmaschine (3), umfassend einen Generator (4) mit einem Abgaseintritt (5) und einem Abgasaustritt (6) und einem Wärmeaustauschabschnitt (7) dazwischen, wobei der Wärmeaustauschabschnitt (7) eine Vielzahl von Strömungspfaden (8) für das Abgas (2) aufweist, wobei die Strömungspfade (8) zumindest teilweise von thermoelektrischen Elementen (9) umgeben sind, die auf der dem Strömungspfad (8) abgewandten Seite (10) mit einer Kühleinrichtung (11) in wärmeleitender Verbindung stehen, wobei wenigstens ein Strömungspfad (8) Elemente zur Strömungsbeeinflussung aufweist, wobei die Elemente zur Strörmmgsbeemflussung
• Strukturen (19) oder Profilierungen (20), die an ersten Wandungen (21) des Strömungspfades (8) angeordnet sind,
• oder Wärmeleitstrukturen (16) sind, **dadurch gekennzeichnet, dass** die Elemente zur Strömungsbeeinflussung in den stromabwärts gelegenen Abschnitten der Strömungspfade (8) angeordnet sind, so dass in Bereichen kälteren Abgases (2) die vorhandene Restwärme des Abgases (2) zu einem größeren Teil aus dem Abgasstrom abgeführt werden kann und gleichzeitig ein Überhitzen von thermoelektrischen Elementen (9) in Bereichen heißeren Abgases (2)unmittelbar stromabwärts von dem Abgaseintritt (5) des Generators (4) verhindert wird.

2. Vorrichtung (1) nach Patentanspruch 1, wobei entlang eines Strömungspfades (8) thermoelektrische Elemente (9) unterschiedlicher Art vorgesehen sind.

3. Vorrichtung (1) nach Patentanspruch 2, wobei die thermoelektrischen Elemente (9) unterschiedliche Wirkungsgradmaxima in Bezug auf eine durchschnittliche Abgastemperatur aufweisen und hinsichtlich ihres unterschiedlichen Wirkungsgrades in einem ersten Abschnitt (12) oder in zumindest einem zweiten Abschnitt (13) eines Strömungspfades (8) angeordnet sind.

4. Vorrichtung (1) nach einem der vorhergehenden Patentansprüche, wobei zumindest ein Strömungspfad (8) wenigstens eine Leitschaufel (15) oder eine Wärmeleitstruktur (16) aufweist.

5. Vorrichtung (1) nach einem der vorhergehenden Patentansprüche, wobei mit zunehmendem Staudruck (22) das Abgas (2) innerhalb zumindest eines Strömungspfades (8) zumindest teilweise in einen benachbarten Bypass-Strömungspfad (23) überführt wird, wobei der Bypass-Strömungspfad (23) parallel verläuft und nicht in direktem Kontakt mit den thermoelektrischen Elementen (9) steht und insbesondere durch eine zweite Wandung (26) von dem Strömungspfad getrennt ist, der unmittelbar mit den thermoelektrischen Elementen (9) in Wärme leitenden Kontakt steht.

6. Vorrichtung (1) nach Patentanspruch 5, wobei ein Bypass-Strömungspfad (23) durch einen in dem Strömungspfad (8) angeordneten Körper (24) mit einer offenen Grundfläche (25) gebildet wird, der sich entgegen der Strömungsrichtung (14) des Abgases (2) innerhalb des Strömungspfades (8) verjüngt und eine für das Abgas (2) durchströmbare zweite Wandung (26) aufweist.

7. Vorrichtung (1) nach einem der vorhergehenden Patentansprüche, wobei stromaufwärts von dem Wärmeaustauschabschnitt (7) zumindest ein Oxidationskatalysator (27) vorgesehen ist.

8. Vorrichtung (1) nach Anspruch 7, wobei der Oxidationskatalysator (27) beheizbar ist.

9. Vorrichtung (1) nach einem der vorhergehenden Patentansprüche, wobei stromabwärts von dem Wärmeaustauschabschnitt (7) zumindest ein NOₓ-Speicher (28) vorgesehen ist.

10. Verfahren zur Erzeugung elektrischer Energie aus einem Abgas (2) einer Verbrennungskraftmaschine (3) durch eine Vorrichtung (1); gemäß einem der vorhergehenden Patentansprüche, wobei der wärmeleitende Kontakt des Abgases (2) mit den thermoelektrischen Elementen (9) zumindest in Abhängigkeit des Gesamtmassenstroms oder der Temperatur (33) des Abgases (2) geregelt wird.

11. Verfahren nach Patentanspruch 10, wobei der wärmeleitende Kontakt des Abgases (2) mit den thermoelektrischen Elementen (9) zumindest in Abhängigkeit des Gesamtmassenstroms oder der Temperatur (33) des Abgases (2) selbstregulierend geregelt wird.

12. Verfahren nach Patentanspruch 11, wobei ein Überlastschutz (17) in Abhängigkeit des Staudrucks (22) des Abgases (2) selbstregulierend eine strömungstechnische Abtrennung einer größer werdenden Menge an Abgas (2) von ersten Wandungen (21) eines Strömungspfades (8) bewirkt.

13. Kraftfahrzeug (29) mit einer Verbrennungskraftmaschine (3) und mit einer Vorrichtung (1) zur Erzeugung von elektrischer Energie aus einem Abgas (2) gemäß einem der Patentansprüche 1 bis 9 oder betreibbar durch ein Verfahren gemäß einem der Patentansprüche 10 bis 12.

## Claims

1. Device (1) for producing electrical energy from the exhaust gas (2) of an internal combustion engine (3), comprising a generator (4) having an exhaust gas inlet (5) and an exhaust gas outlet (6) and a heat exchange portion (7) between them, wherein the heat exchange portion (7) has a plurality of flow paths (8) for the exhaust gas (2), wherein the flow paths (8) are at least partially surrounded by thermoelectric elements (9) which, on the side (10) facing away from the flow path (8), are connected in thermally conductive fashion to a cooling device (11), wherein at least one flow path (8) has elements for flow manipulation, wherein the elements for flow manipulation are
• structures (19) or profilings (20) which are arranged on first walls (21) of the flow path (8),
• or thermally conductive structures (16), **characterized in that** the elements for flow manipulation are arranged in the downstream portions of the flow paths (8), such that in regions of relatively cold exhaust gas (2), the existing residual heat of the exhaust gas (2) can be dissipated to a greater extent from the exhaust-gas flow, and at the same time, overheating of thermoelectric elements (9) in regions of relatively hot exhaust gas (2) directly downstream of the exhaust gas inlet (5) of the generator (4) is prevented.

2. Device (1) according to Patent Claim 1, wherein thermoelectric elements (9) of different type are provided along a flow path (8).

3. Device (1) according to Patent Claim 2, wherein the thermoelectric elements (9) have different efficiency maxima in relation to an average exhaust-gas temperature, and with regard to their different efficiencies are arranged in a first portion (12) or in at least one second portion (13) of a flow path (8).

4. Device (1) according to one of the preceding patent claims, wherein at least one flow path (8) has at least one guide blade (15) or a thermally conductive structure (16) .

5. Device (1) according to one of the preceding patent claims, wherein with increasing dynamic pressure (22), the exhaust gas (2) within at least one flow path (8) is at least partially transferred into an adjacent bypass flow path (23), wherein the bypass flow path (23) runs parallel and is not in direct contact with the thermoelectric elements (9), and is in particular separated by a second wall (26) from the flow path which is in direct thermally conductive contact with the thermoelectric elements (9).

6. Device (1) according to Patent Claim 5, wherein a bypass flow path (23) is formed by a body (24) which is arranged in the flow path (8) and which has an open base surface (25) and which tapers counter to the flow direction (14) of the exhaust gas (2) within the flow path (8) and which has a second wall (26) through which the exhaust gas (2) can flow.

7. Device (1) according to one of the preceding patent claims, wherein at least one oxidation catalytic converter (27) is provided upstream of the heat exchange portion (7) .

8. Device (1) according to Claim 7, wherein the oxidation catalytic converter (27) is heatable.

9. Device (1) according to one of the preceding patent claims, wherein at least one NOₓ accumulator (28) is provided downstream of the heat exchange portion (7).

10. Method for producing electrical energy from the exhaust gas (2) of an internal combustion engine (3) by means of a device (1) according to one of the preceding patent claims, wherein the thermally conductive contact between the exhaust gas (2) and the thermoelectric elements (9) is regulated at least as a function of the overall mass flow or the temperature (33) of the exhaust gas (2).

11. Method according to Patent Claim 10, wherein the thermally conductive contact between the exhaust gas (2) and the thermoelectric elements (9) is regulated in a self-regulating manner at least as a function of the overall mass flow or the temperature (33) of the exhaust gas (2).

12. Method according to Patent Claim 11, wherein an overload protection means (17) causes an increasing amount of exhaust gas (2) to be separated in terms of flow from first walls (21) of a flow path (8) in a self-regulating manner as a function of the dynamic pressure (22) of the exhaust gas (2).

13. Motor vehicle (29) having an internal combustion engine (3) and having a device (1) for producing electrical energy from the exhaust gas (2) according to one of Patent Claims 1 to 9, or operable by means of a method according to one of Patent Claims 10 to 12.

## Revendications

1. Ensemble (1) pour la production d'énergie électrique à partir des gaz d'échappement (2) d'un moteur (3) à combustion interne, l'ensemble comprenant un générateur (4) doté d'une entrée (5) de gaz d'échappement et d'une sortie (6) de gaz d'échappement avec entre elles une section (17) d'échange de chaleur, la section (7) d'échange de chaleur présentant plusieurs parcours d'écoulement (8) pour le gaz d'échappement (2), les parcours d'écoulement (8) étant au moins en partie entourés par des éléments thermoélectriques (9) reliés de manière thermiquement conductrice à un dispositif de refroidissement (11) sur le côté (10) non tourné vers le parcours d'écoulement (8),
un parcours d'écoulement (8) présentant des éléments agissant sur l'écoulement, les éléments agissant sur l'écoulement étant
des structures (19) ou des profils (20) disposés sur des premières parois (21) du parcours d'écoulement (8) ou
des structures thermiquement conductrices (16), **caractérisé en ce que**
les éléments agissant sur l'écoulement sont disposés dans les sections des parcours d'écoulement (8) situées en aval, de telle sorte que dans les parties occupées par du gaz d'échappement (2) plus froid, la chaleur résiduelle présente dans les gaz d'échappement (2) puisse être évacuée de manière plus intense de l'écoulement de gaz d'échappement et qu'en même temps la surchauffe d'éléments thermoélectriques (9) dans les parties occupées par les gaz d'échappement (2) plus chauds immédiatement en aval de l'entrée (5) des gaz d'échappement du générateur (4) soit empêchée.

2. Ensemble (1) selon la revendication 1, dans lequel des éléments thermoélectriques (9) de différents types sont prévus le long d'un parcours d'écoulement (8).

3. Ensemble (1) selon la revendication 2, dans lequel les éléments thermoélectriques (9) présentent différents maximums de rendement par rapport à une température moyenne des gaz d'échappement, leurs différents rendements prévalant dans une première section (12) ou dans au moins une deuxième section (13) d'un parcours d'écoulement (8).

4. Ensemble (1) selon l'une des revendications précédentes, dans lequel au moins un parcours d'écoulement (8) présente au moins une aube de guidage (15) ou une structure (16) thermiquement conductrice.

5. Ensemble (1) selon l'une des revendications précédentes, dans lequel, lorsque la pression d'accumulation (22) augmente, les gaz d'échappement (2) situés dans au moins un parcours d'écoulement (8) sont transférés au moins en partie dans un parcours d'écoulement de dérivation (23) voisin, le parcours d'écoulement de dérivation (23) s'étendant en parallèle et n'étant pas en contact direct avec les éléments thermoélectriques (9) et en particulier étant séparé par une deuxième paroi (26) du parcours d'écoulement en contact thermiquement conducteur direct avec les éléments thermoélectriques (9).

6. Ensemble (1) selon la revendication 5, dans lequel un parcours d'écoulement de dérivation (23) est formé par un corps (24) disposé dans le parcours d'écoulement (8) et présentant une surface de base (25) ouverte, le corps se rétrécissant à l'intérieur du parcours d'écoulement (8) dans la direction opposée à la direction d'écoulement (14) des gaz d'échappement (2) et présentant une deuxième paroi (26) qui peut être traversée par les gaz d'échappement (2).

7. Ensemble (1) selon l'une des revendications précédentes, dans lequel au moins un catalyseur d'oxydation (27) est prévu en amont de la section (7) d'échange de chaleur.

8. Ensemble (1) selon la revendication 7, dans lequel le catalyseur d'oxydation (27) peut être chauffé.

9. Ensemble (1) selon l'une des revendications précédentes, dans lequel au moins un accumulateur (28) de NOₓ est prévu en aval de la section (7) d'échange de chaleur.

10. Procédé de production d'énergie électrique à partir des gaz d'échappement (2) d'un moteur (3) à combustion interne, par un ensemble (1) selon l'une des revendications précédentes, dans lequel le contact thermiquement conducteur entre les gaz d'échappement (2) et les éléments thermoélectriques (9) est régulé au moins en fonction du débit massique total ou de la température (33) des gaz d'échappement (2).

11. Procédé selon la revendication 10, dans lequel dans lequel le contact thermiquement conducteur entre les gaz d'échappement (2) et les éléments thermoélectriques (9) est régulé de manière autorégulée au moins en fonction du débit massique total ou de la température (33) des gaz d'échappement (2).

12. Procédé selon la revendication 11, dans lequel une protection (17) contre les surcharges en fonction de la pression d'accumulation (22) des gaz d'échappement (2) agit de manière autorégulée pour séparer un débit croissant de gaz d'échappement (2) par des premières parois (21) d'un parcours d'écoulement (8).

13. Véhicule automobile (29) doté d'un moteur (3) à combustion interne et d'un ensemble (1) pour la production d'énergie électrique à partir des gaz d'échappement (2) selon l'une des revendications 1 à 9 ou pouvant être utilisé en appliquant un procédé selon l'une des revendications 10 à 12.
